# EUROPEAN PATENT APPLICATION

(11) **EP 4 700 149 A1**
(43) Date of publication of application: **25.02.2026**
(21) Application number: 25189334.3
(22) Date of filing: 14.07.2025
(51) Int. Cl.: C23C 14/12, C23C 14/24, C23C 16/54

(54) **SUBSTRATE DEPOSITION APPARATUS AND SUBSTRATE DEPOSITION METHOD USING THE SAME**

(30) Priority: 19.07.2024 KR 20240095904
(71) Applicant: Samsung Display Co., Ltd., Yongin-si, Gyeonggi-do 17113 (KR)
(72) Inventor: HAN, Inae, Giheung-Gu, Yongin-si, Gyeonggi-Do (KR); HAN, Jongbun, Giheung-Gu, Yongin-si, Gyeonggi-Do (KR); PARK, Sungjong, Giheung-Gu, Yongin-si, Gyeonggi-Do (KR)
(74) Representative: Dr. Weitzel & Partner

(57) **Abstract**

A substrate deposition method includes placing a substrate in a substrate deposition apparatus and performing a deposition process on the substrate in the substrate deposition apparatus. The substrate deposition apparatus includes a process chamber having a process space, a stage in the process chamber, and a deposition source module. The deposition source module includes a plurality of first deposition sources arranged in a first direction that is a horizontal direction, a plurality of second deposition sources arranged in the first direction, a plurality of third deposition sources arranged in the first direction, and a plurality of fourth deposition sources arranged in the first direction. The performing of the deposition process on the substrate includes heating the deposition source module and moving the deposition source module in a direction parallel to a second direction that is a horizontal direction intersecting the first direction.

## Description

The present invention relates to a substrate deposition apparatus and a substrate deposition method using the substrate deposition apparatus.

Electronic devices that provide an image to a user, such as smartphones, digital cameras, notebook computers, navigation devices, and smart televisions, include a display device to display the images. The display device generates the image and provides the generated image to the user through a display screen.

The display device is manufactured through various processes. As an example, the display device is manufactured through a deposition process, an etching process, and a cleaning process for a substrate. In the deposition process for the substrate, a layer is formed on a surface of the substrate by heating a deposition source, and the layer may include two or more materials.

The invention is defined by the features of the independent claims. The dependent claims and the description provide preferred embodiments.

Embodiments of the present invention provide a substrate deposition apparatus configured to implement various deposition structures and a substrate deposition method using the substrate deposition apparatus.

Embodiments of the present invention also provide a substrate deposition apparatus that improves the lifespan of a product and a substrate deposition method using the substrate deposition apparatus.

Embodiments of the present invention also provide a substrate deposition apparatus configured to perform a deposition process on an entire substrate at once through a linear deposition method and a substrate deposition method using the substrate deposition apparatus.

A substrate deposition method, according to an embodiment of the present invention, includes placing a substrate in a substrate deposition apparatus and performing a deposition process on the substrate in the substrate deposition apparatus. The substrate deposition apparatus includes a process chamber having a process space, a stage in the process chamber, and a deposition source module. The deposition source module includes a plurality of first deposition sources arranged in a first direction that is a horizontal direction, a plurality of second deposition sources arranged in the first direction, a plurality of third deposition sources arranged in the first direction, and a plurality of fourth deposition sources arranged in the first direction. The performing of the deposition process on the substrate includes heating the deposition source module and moving the deposition source module in a direction parallel to a second direction that is a horizontal direction intersecting the first direction.

A substrate deposition method, according to an embodiment of the present invention, includes placing a substrate in a substrate deposition apparatus and performing a deposition process on the substrate using the substrate deposition apparatus. The substrate deposition apparatus includes a process chamber having a process space, a stage in the process chamber, and a deposition source module. The deposition source module includes a first deposition source, a second deposition source, a third deposition source, and a fourth deposition source, which are sequentially arranged in a horizontal direction. The performing of the deposition process on the substrate includes heating the deposition source module and moving the deposition source module in the horizontal direction. The first deposition source includes a first deposition material, the second deposition source includes a second deposition material that is different from the first deposition material, the third deposition source includes a third deposition material that is different from the second deposition material, and the fourth deposition source includes a fourth deposition material that is the same as the second deposition material.

A substrate deposition apparatus, according to an embodiment of the present invention, includes a process chamber having a process space, a stage in the process chamber, and a deposition source module. The deposition source module includes a plurality of first deposition sources arranged in a first direction that is a horizontal direction, a plurality of second deposition sources arranged in the first direction, a plurality of third deposition sources arranged in the first direction, and a plurality of fourth deposition sources arranged in the first direction. The second deposition sources are spaced apart from the first deposition sources in a direction parallel to a second direction intersecting the first direction.

According to embodiments of the present invention, various deposition structures are implemented using the substrate deposition apparatus and the substrate deposition method using the substrate deposition apparatus.

According to embodiments of the present invention, a lifespan of a product is improved by using the substrate deposition apparatus and the substrate deposition method using the substrate deposition apparatus.

According to embodiments of the present invention, the deposition process is performed on an entire substrate at once through a linear deposition method using the substrate deposition apparatus and the substrate deposition method using the substrate deposition apparatus.

The above and other aspects and features of the present invention will become readily apparent by reference to the following detailed description when considered in conjunction with the accompanying drawings, in which:
FIG. 1 is a cross-sectional view of a substrate deposition apparatus according to an embodiment of the present invention;
FIG. 2 is a cross-sectional view of a substrate deposition apparatus according to an embodiment of the present invention;
FIG. 3 is a cross-sectional view of a deposition source module according to an embodiment of the present invention;
FIG. 4 is an enlarged cross-sectional view of the area X in FIG. 3;
FIG. 5 is a plan view of a deposition source module according to an embodiment of the present invention;
FIG. 6 is an enlarged plan view of the area Y in FIG. 5;
FIG. 7 is a flowchart describing steps of a substrate deposition method according to an embodiment of the present invention;
FIGS. 8 to 11 are views illustrating steps of the substrate deposition method according to the embodiment described in FIG. 7;
FIG. 12 is a cross-sectional view of a deposition source module according to an embodiment of the present invention;
FIG. 13 is a cross-sectional view of a deposition source module according to an embodiment of the present invention; and
FIG. 14 is a cross-sectional view of a deposition source module according to an embodiment of the present invention.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

A person of ordinary skill in the art would appreciate, in view of the present invention in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

Hereinafter, embodiments of a substrate deposition apparatus and a substrate deposition method using the substrate deposition apparatus according to the present invention will be described with reference to accompanying drawings.

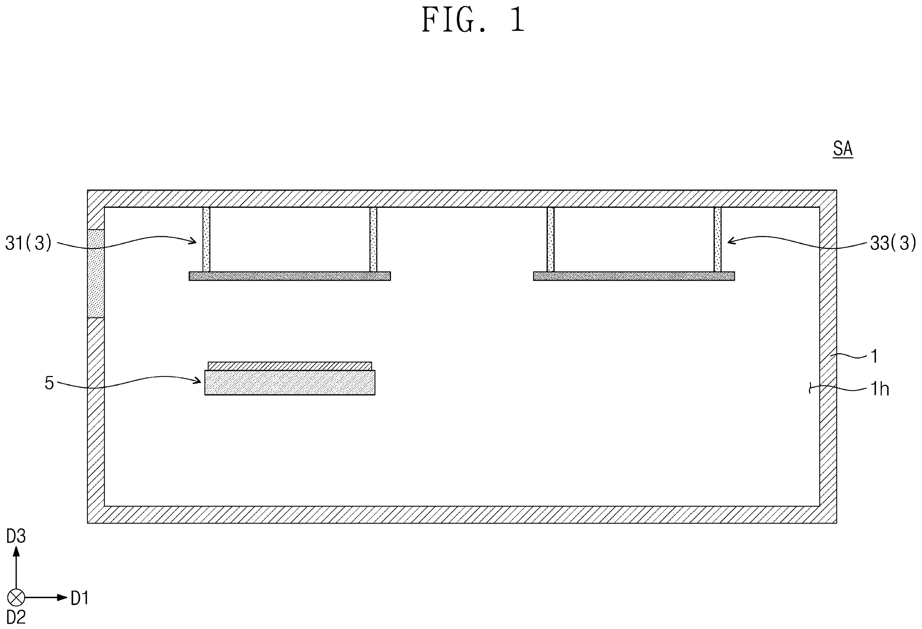

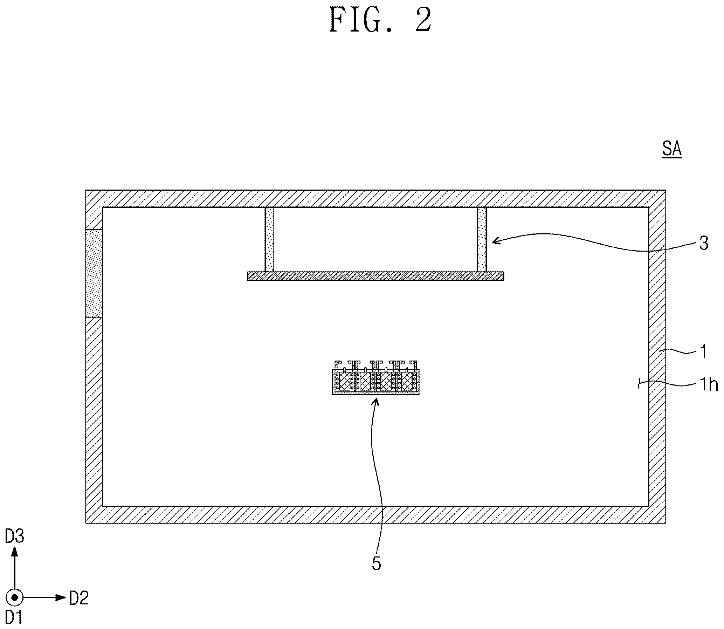

FIG. 1 is a cross-sectional view of the substrate deposition apparatus SA according to an embodiment of the present invention, and FIG. 2 is a cross-sectional view of the substrate deposition apparatus SA according to an embodiment of the present invention.

Hereinafter, D1 is referred to as a first direction, D2 crosses (e.g., intersects) the first direction D1 and is referred to as a second direction, and D3 crosses (e.g., intersects) each of the first direction D1 and the second direction D2 and is referred to as a third direction. The third direction D3 may be referred to as a vertical direction. In addition, each of the first direction D1 and the second direction D2 may be referred to as a horizontal direction.

Referring to FIGS. 1 and 2, the substrate deposition apparatus SA may be provided. The substrate deposition apparatus SA may be a chamber in which a deposition process is performed on a substrate. For example, the substrate deposition apparatus SA may be an apparatus that heats a deposition source (e.g., a deposition material) and forms a deposition layer on the substrate to manufacture a display device. The substrate deposition apparatus SA may include a process chamber 1, a stage 3, and a deposition source module 5.

The process chamber 1 may include (of may form) a process space 1h. The process space 1h may be separated from an external space by the process chamber 1. The deposition process may be performed on the substrate in the process space 1h. During the deposition process for the substrate in the process space 1h, the process space 1h may be maintained in a vacuum state. To this end, the process space 1h may be connected to a vacuum pump, however, the present invention should not be limited thereto or thereby.

The stage 3 may be placed in (or arranged in) the process chamber 1. The stage 3 may support (e.g., may suspend) the substrate. The deposition process may be performed on the substrate when the substrate is disposed on the stage 3. A hole (e.g., an opening) may be formed through a center of the stage 3 to expose a lower surface of the substrate downwardly when the substrate is disposed on the stage 3. Two stages 3 may be provided in one process space 1h. For example, referring to FIG. 1, a first stage 31 and a second stage 33 may be provided. The first stage 31 and the second stage 33 may be arranged to be spaced apart from each other in the first direction D1. The deposition process may be performed when a substrate is disposed on each of the first stage 31 and the second stage 33. When two substrates are placed in one process chamber 1, the deposition process may be performed on the two substrates concurrently or simultaneously. However, for the convenience of explanation, an embodiment in which the stage 3 is singular will be described below.

The deposition source module 5 may be placed in the process space 1h. For example, the deposition source module 5 may be disposed under the stage 3. The deposition source module 5 may move in one or both of the horizontal directions. As an example, the deposition source module 5 may move in the second direction D2. Accordingly, the deposition source module 5 may be connected to a deposition source driving device (e.g., a deposition source driver). The deposition process may be performed on the substrate while the deposition source module 5 moves. A deposition material vaporized from the deposition source module 5 may be deposited on the substrate to form the deposition layer. This will be described in more detail later. One deposition source module 5 may be provided in one process chamber 1. For example, with respect to the embodiment shown in FIG. 1, the deposition process may be performed on the substrates respectively disposed on the two stages 31 and 33 by using one deposition source module 5. To this end, the deposition source module 5 may move in the first direction D1. However, the present invention should not be limited thereto or thereby. According to an embodiment, two deposition source modules may be provided. The deposition source module 5 will be described in more detail later.

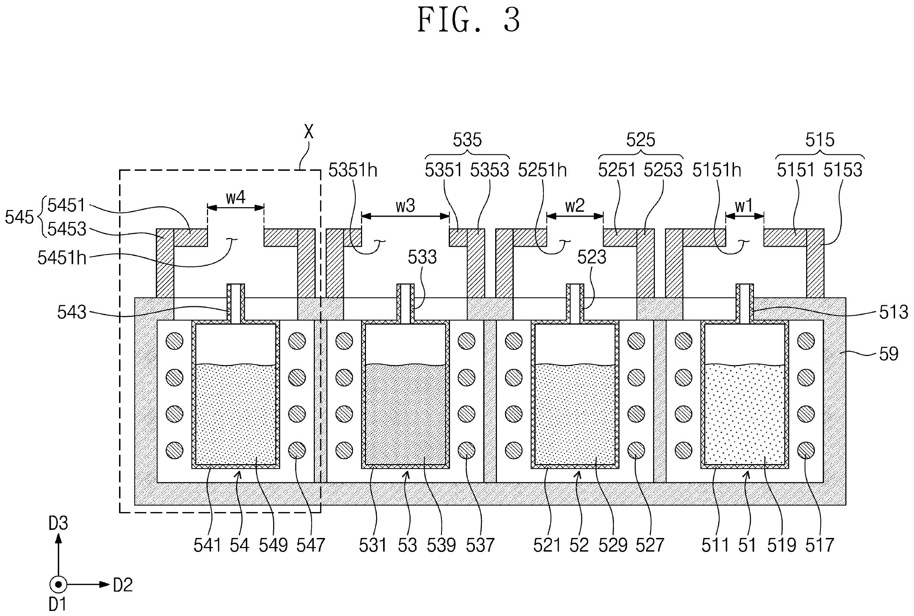

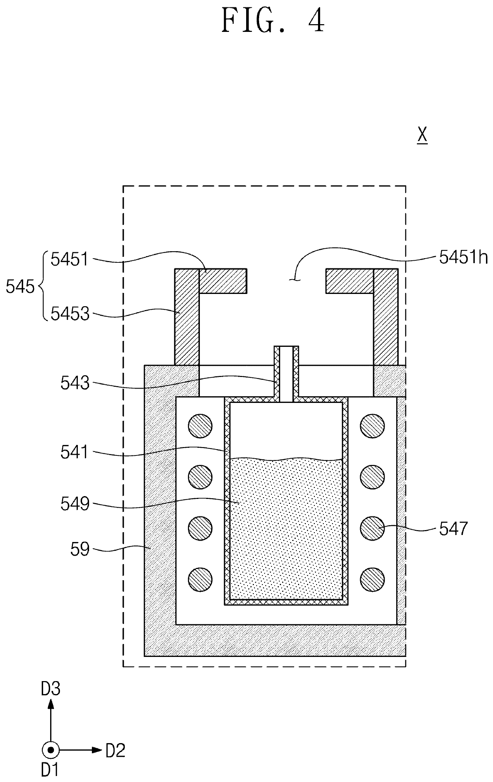

FIG. 3 is a cross-sectional view of the deposition source module according to an embodiment of the present invention, and FIG. 4 is an enlarged cross-sectional view of the area X in FIG. 3.

Referring to FIGS. 3 and 4, the deposition source module 5 may include a first deposition source 51, a second deposition source 52, a third deposition source 53, a fourth deposition source 54, and a module housing 59.

The first deposition source 51 may include a first deposition housing 511, a first nozzle 513, a first deposition material 519, a first blocking member 515, and a first heater 517. The first deposition housing 511 may provide (or may form) a first storage space. The first deposition material 519 may be stored in the first deposition housing 511. The first nozzle 513 may be placed on the first deposition housing 511. The first nozzle 513 may be connected to (e.g., may be in fluid communication with) the first storage space in the first deposition housing 511. The first deposition material 519 stored in the first storage space may be discharged to an outside of the first deposition housing 511 through the first nozzle 513. The first deposition material 519 may be filled in the first deposition housing 511. When the first deposition material 519 in the first deposition housing 511 is heated, at least a portion of the first deposition material 519 may be vaporized. The vaporized first deposition material 519 may be discharged to the outside through the first nozzle 513. The first deposition material 519 may include, for example, Alq₃ (Al(C₉H₆NO)₃), that isTris(8-hydroxyquinolinato)aluminium, however, the present invention should not be limited thereto or thereby. The first blocking member 515 may be disposed above the first deposition housing 511. The first blocking member 515 may include a first blocking plate 5151 and a first support member 5153. The first blocking plate 5151 may be disposed above the first nozzle 513. For example, the first blocking plate 5151 may be placed spaced apart upwardly from (e.g., may be arranged to be spaced apart vertically from) the first nozzle 513. The first blocking plate 5151 may have a first blocking hole (e.g., a first blocking opening) 5151h. The first blocking hole 5151h may penetrate (e.g., may extend through) the first blocking plate 5151 from top to bottom. The first blocking hole 5151h may have a rectangular shape when viewed in a plane; however, the present invention should not be limited thereto or thereby. The first blocking hole 5151h may have a first width (or first diameter) w1. The first support member 5153 may support the first blocking plate 5151. The first heater 517 may surround (e.g., may extend around) the first deposition housing 511. The first deposition material 519 in the first deposition housing 511 may be heated by the first heater 517.

The second deposition source 52 may include a second deposition housing 521, a second nozzle 523, a second deposition material 529, a second blocking member 525, and a second heater 527. The second deposition housing 521 may provide (or may form) a second storage space. The second deposition material 529 may be stored in the second deposition housing 521. The second nozzle 523 may be placed on the second deposition housing 521. The second nozzle 523 may be connected to (e.g., may be in fluid communication with) the second storage space in the second deposition housing 521. The second deposition material 529 stored in the second storage space may be discharged to an outside of the second deposition housing 521 through the second nozzle 523. The second deposition material 529 may be filled in the second deposition housing 521. When the second deposition material 529 in the second deposition housing 521 is heated, at least a portion of the second deposition material 529 may be vaporized. The vaporized second deposition material 529 may be discharged to the outside through the second nozzle 523. The second deposition material 529 may include a material different from that of the first deposition material 519; however, the present invention should not be limited thereto or thereby. The second blocking member 525 may be placed above the second deposition housing 521. The second blocking member 525 may include a second blocking plate 5251 and a second support member 5253. The second blocking plate 5251 may be placed above the second nozzle 523. For example, the second blocking plate 5251 may be placed spaced apart upwardly from (e.g., may be arranged to be spaced apart vertically from) the second nozzle 523. The second blocking plate 5251 may have a second blocking hole (e.g., a second blocking opening) 5251h. The second blocking hole 5251h may penetrate (e.g., may extend through) the second blocking plate 5251 from top to bottom. The second blocking hole 5251h may have a rectangular shape when viewed in the plane; however, the present invention should not be limited thereto or thereby. The second blocking hole 5251h may have a second width (or second diameter) w2. The second width w2 may be different from the first width w1. In one embodiment, the second width w2 may be greater than the first width w1. The second support member 5253 may support the second blocking plate 5251. The second heater 527 may surround (e.g., may extend around) the second deposition housing 521. The second deposition material 529 in the second deposition housing 521 may be heated by the second heater 527. The second heater 527 may be controlled independently from the first heater 517. Accordingly, the second deposition material 529 stored in the second deposition housing 521 may be heated at a temperature different from the first deposition material 519.

The third deposition source 53 may include a third deposition housing 531, a third nozzle 533, a third deposition material 539, a third blocking member 535, and a third heater 537. The third deposition housing 531 may provide (or may form) a third storage space. The third deposition material 539 may be stored in the third deposition housing 531. The third nozzle 533 may be placed on the third deposition housing 531. The third nozzle 533 may be connected to (e.g., may be in fluid communication with) the third storage space in the third deposition housing 531. The third deposition material 539 stored in the third storage space may be discharged to an outside of the third deposition housing 531 through the third nozzle 533. The third deposition material 539 may be filled in the third deposition housing 531. When the third deposition material 539 stored in the third deposition housing 531 is heated, at least a portion of the third deposition material 539 may be vaporized. The vaporized third deposition material 539 may be discharged to the outside through the third nozzle 533. The third deposition material 539 may include a material different from that of the first deposition material 519; however, the present invention should not be limited thereto or thereby. The third blocking member 535 may be placed above the third deposition housing 531. The third blocking member 535 may include a third blocking plate 5351 and a third support member 5353. The third blocking plate 5351 may be placed above the third nozzle 533. For example, the third blocking plate 5351 may be placed spaced apart upwardly from (e.g., may be arranged to be spaced apart vertically from) the third nozzle 533. The third blocking plate 5351 may have a third blocking hole (e.g., a third blocking opening) 5351h. The third blocking hole 5351h may penetrate (e.g., may extend through) the third blocking plate 5351 from top to bottom. The third blocking hole 5351h may have a rectangular shape when viewed in the plane; however, the present invention should not be limited thereto or thereby. The third blocking hole 5351h may have a third width (or a third diameter) w3. The third width w3 may be different from each of the first width w1 and the second width w2. In one embodiment, the third width w3 may be greater than each of the first width w1 and the second width w2. The third support member 5353 may support the third blocking plate 5351. The third heater 537 may surround (e.g., may extend around) the third deposition housing 531. The third deposition material 539 stored in the third deposition housing 531 may be heated by the third heater 537. The third heater 537 may be controlled independently from each of the first heater 517 and the second heater 527. Accordingly, the third deposition material 539 stored in the third deposition housing 531 may be heated at a temperature different from the first deposition material 519 and/or the second deposition material 529.

The fourth deposition source 54 may include a fourth deposition housing 541, a fourth nozzle 543, a fourth deposition material 549, a fourth blocking member 545, and a fourth heater 547. The fourth deposition housing 541 may provide (or may form) a fourth storage space. The fourth deposition material 549 may be stored in the fourth deposition housing 541. The fourth nozzle 543 may be placed on the fourth deposition housing 541. The fourth nozzle 543 may be connected to (e.g., may be in fluid communication with) the fourth storage space in the fourth deposition housing 541. The fourth deposition material 549 stored in the fourth storage space may be discharged to an outside of the fourth deposition housing 541 through the fourth nozzle 543. The fourth deposition material 549 may be filled in the fourth deposition housing 541. When the fourth deposition material 549 stored in the fourth deposition housing 541 is heated, at least a portion of the fourth deposition material 549 may be vaporized. The vaporized fourth deposition material 549 may be discharged to the outside through the fourth nozzle 543. The fourth deposition material 549 may include a material different from that of the first deposition material 519. As an example, the fourth deposition material 549 may include substantially the same material as or similar material to that of the second deposition material 529; however, the present invention should not be limited thereto or thereby. The fourth deposition material 549 may include a material different from that of the second deposition material 529. As an example, the material included in the fourth deposition material 549 may have a refractive index or a light absorption rate different from a refractive index or a light absorption rate of the material included in the second deposition material 529. The fourth blocking member 545 may be placed above the fourth deposition housing 541. The fourth blocking member 545 may include a fourth blocking plate 5451 and a fourth support member 5453. The fourth blocking plate 5451 may be placed above the fourth nozzle 543. For example, the fourth blocking plate 5451 may be placed spaced apart upwardly from (e.g., may be arranged to be spaced apart vertically from) the fourth nozzle 543. The fourth blocking plate 5451 may have a fourth blocking hole (e.g., a fourth blocking opening) 5451h. The fourth blocking hole 5451h may penetrate (e.g., may extend through) the fourth blocking plate 5451 from top to bottom. The fourth blocking hole 5451h may have a rectangular shape when viewed in the plane; however, the present invention should not be limited thereto or thereby. The fourth blocking hole 5451h may have a fourth width (or a fourth diameter) w4. The fourth width w4 may be different from each of the first width w1 and the third width w3. As an example, the fourth width w4 may be substantially the same as or similar to the second width w2. The fourth support member 5453 may support the fourth blocking plate 5451. The fourth heater 547 may surround (e.g., may extend around) the fourth deposition housing 541. The fourth deposition material 549 stored in the fourth deposition housing 541 may be heated by the fourth heater 547. The fourth heater 547 may be controlled independently from each of the first heater 517, the second heater 527, and the third heater 537. Accordingly, the fourth deposition material 549 stored in the fourth deposition housing 541 may be heated at a temperature different from the first deposition material 519, the second deposition material 529, and/or the third deposition material 539.

The first deposition source 51, the second deposition source 52, the third deposition source 53, and the fourth deposition source 54 may be arranged in a direction parallel to the second direction D2. In one embodiment, the second deposition source 52 may be disposed spaced apart from the first deposition source 51 in the direction parallel to the second direction D2. However, the present invention should not be limited thereto or thereby, and in another embodiment, the second deposition source 52 and the first deposition source 51 may be adjacent to each other while being arranged in the direction parallel to the second direction D2.

The module housing 59 may surround the first deposition source 51, the second deposition source 52, the third deposition source 53, and the fourth deposition source 54. For example, the first deposition source 51, the second deposition source 52, the third deposition source 53, and the fourth deposition source 54 may be placed in (or arranged in) the module housing 59; however, the present invention should not be limited thereto or thereby. According to an embodiment, the first deposition source 51, the second deposition source 52, the third deposition source 53, and the fourth deposition source 54 may be coupled with each other without a separate module housing.

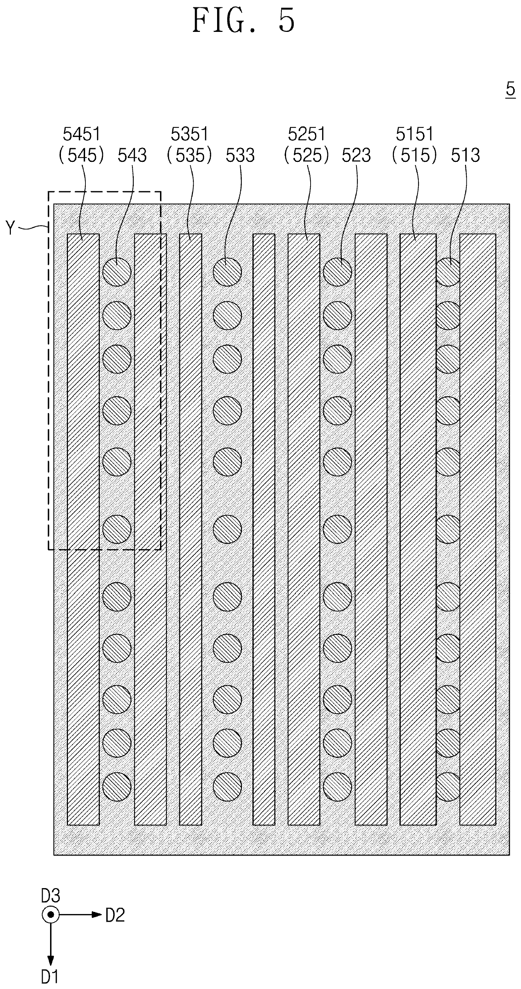

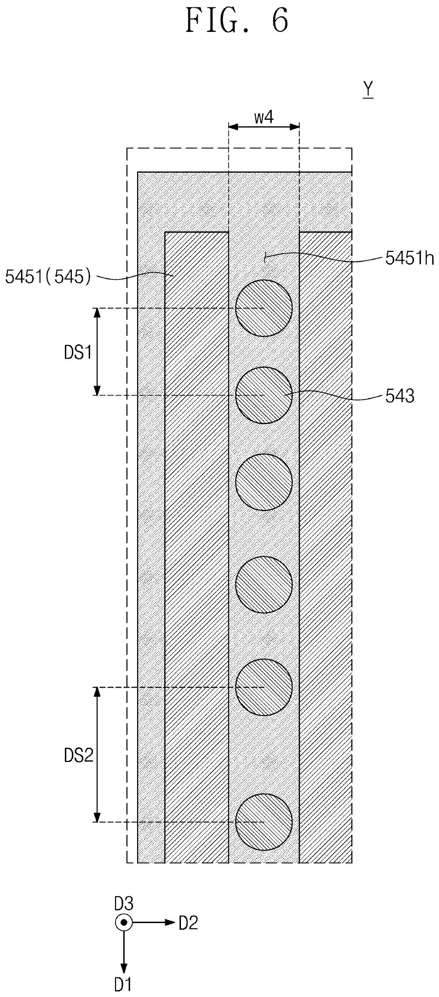

FIG. 5 is a plan view of the deposition source module 5 according to an embodiment of the present invention, and FIG. 6 is an enlarged plan view of the area Y in FIG. 5.

Referring to FIGS. 3, 5, and 6, the first deposition source 51 may be provided in plural. The first deposition sources 51 may be arranged in the first direction D1. For example, the deposition source module 5 of the substrate deposition apparatus SA (see, e.g., FIG. 1) may be a linear deposition module for a linear deposition. When the first deposition source 51 is provided in plural, the first nozzle 513 may also be provided in plural. The first nozzles 513 may be arranged in the first direction D1. From among the first deposition sources 51, a first distance DS1 that is a separation distance in the first direction D1 between two first deposition sources 51 adjacent to an edge (or an end) of the first blocking plate 5151 may be different from a second distance DS2 that is a separation distance in the first direction D1 between two first deposition sources 51 at (or nearer to) a center of the first blocking plate 5151. The first distance DS1 may be a distance in the first direction D1 between two first nozzles 513 adjacent to each other at the edge of the first blocking plate 5151. The second distance DS2 may be a distance in the first direction D1 between two first nozzles 513 adjacent to each other at (or near) the center of the first blocking plate 5151. The second distance DS2 may be greater than the first distance DS1. For example, the first distance DS1 may be smaller than the second distance DS2, and thus, the first deposition sources 51 may be arranged more densely at the edge of the first blocking plate 5151 than at the center of the first blocking plate 5151. However, for the convenience of explanation, an embodiment in which the first deposition source 51 has a singular form is described below.

The second deposition source 52 may be provided in plural. The second deposition sources 52 may be arranged in the first direction D1. For example, the deposition source module 5 of the substrate deposition apparatus SA (see, e.g., FIG. 1) may be a linear deposition module for a linear deposition. When the second deposition source 52 is provided in plural, the second nozzle 523 may also be provided in plural. The second nozzles 523 may be arranged in the first direction D1. From among the second deposition sources 52, a first distance DS1 that is a separation distance in the first direction D1 between two second deposition sources 52 adjacent to an edge (or an end) of the second blocking plate 5251 may be different from a second distance DS2 that is a separation distance in the first direction D1 between two second deposition sources 52 at (or near) a center of the second blocking plate 5251. The first distance DS1 may be a distance in the first direction D1 between two second nozzles 523 adjacent to each other at the edge of the second blocking plate 5251. The second distance DS2 may be a distance in the first direction D1 between two second nozzles 523 adjacent to each other at the center of the second blocking plate 5251. The second distance DS2 may be greater than the first distance DS1. For example, the first distance DS1 may be smaller than the second distance DS2, and thus, the second deposition sources 52 may be arranged more densely at the edge of the second blocking plate 5251 than at the center of the second blocking plate 5251. However, for the convenience of explanation, an embodiment in which the second deposition source 52 has a singular form below is described below.

The third deposition source 53 may be provided in plural. The third deposition sources 53 may be arranged in the first direction D1. That is, the deposition source module 5 of the substrate deposition apparatus SA (see, e.g., FIG. 1) may be a linear deposition module for a linear deposition. When the third deposition source 53 is provided in plural, the third nozzle 533 may also be provided in plural. The third nozzles 533 may be arranged in the first direction D1. From among the third deposition sources 53, a first distance DS1 that is a separation distance in the first direction D1 between two third deposition sources 53 adjacent to an edge of the third blocking plate 5351 may be different from a second distance DS2 that is a separation distance in the first direction D1 between two third deposition sources 53 at (or near) a center of the third blocking plate 5351. The first distance DS1 may be a distance in the first direction D1 between two third nozzles 533 adjacent to each other at the edge of the third blocking plate 5351. The second distance DS2 may be a distance in the first direction D1 between two third nozzles 533 adjacent to each other at the center of the third blocking plate 5351. The second distance DS2 may be greater than the first distance DS1. For example, the first distance DS1 may be smaller than the second distance DS2, and thus, the third deposition sources 53 may be arranged more densely at the edge of the third blocking plate 5351 than at the center of the third blocking plate 5351. However, for the convenience of explanation, an embodiment in which the third deposition source 53 has a singular form is described below.

The fourth deposition source 54 may be provided in plural. The fourth deposition sources 54 may be arranged in the first direction D1. That is, the deposition source module 5 of the substrate deposition apparatus SA (see, e.g., FIG. 1) may be a linear deposition module for a linear deposition. When the fourth deposition source 54 is provided in plural, the fourth nozzle 543 may also be provided in plural. The fourth nozzles 543 may be arranged in the first direction D1. From among the fourth deposition sources 54, a first distance DS1 that is a separation distance in the first direction D1 between two fourth deposition sources 54 adjacent to an edge of the fourth blocking plate 5451 may be different from a second distance DS2 that is a separation distance in the first direction D1 between two fourth deposition sources 54 at a center of the fourth blocking plate 5451. The first distance DS1 may be a distance in the first direction D1 between two fourth nozzles 543 adjacent to each other at the edge of the fourth blocking plate 5451. The second distance DS2 may be a distance in the first direction D1 between two fourth nozzles 543 adjacent to each other at the center of the fourth blocking plate 5451. The second distance DS2 may be greater than the first distance DS1. For example, the first distance DS1 may be smaller than the second distance DS2, and thus, the fourth deposition sources 54 may be arranged more densely at the edge of the fourth blocking plate 5451 than at the center of the fourth blocking plate 5451. However, for the convenience of explanation, an embodiment in which the fourth deposition source 54 has a singular form will be described below.

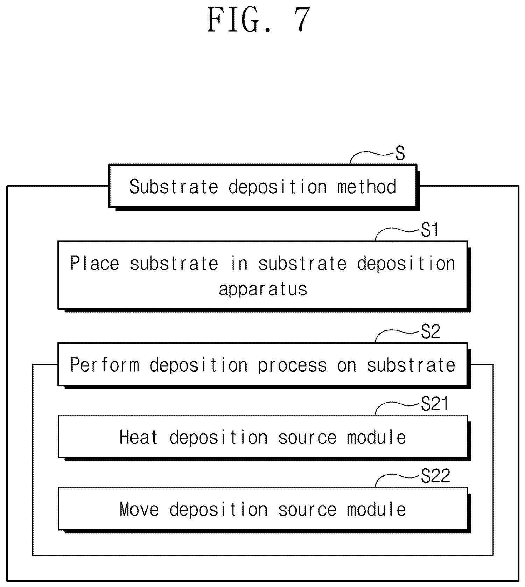

FIG. 7 is a flowchart describing a substrate deposition method according to an embodiment of the present invention.

Referring to FIG. 7, the substrate deposition method S according to an embodiment may be provided. According to the substrate deposition method S, the deposition layer may be formed on the substrate by using the substrate deposition apparatus SA (see, e.g., FIG. 1) described with reference to FIGS. 1 to 6. The substrate deposition method S may include placing the substrate in the substrate deposition apparatus (S1) and performing the deposition process on the substrate (S2).

The performing of the deposition process on the substrate (S2) may include heating the deposition source module (S21) and moving the deposition source module (S22).

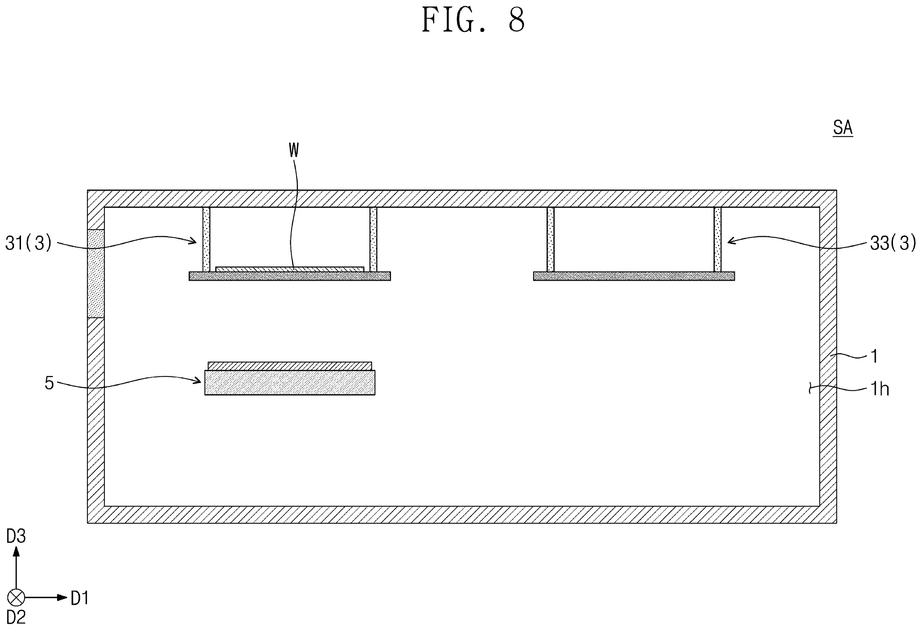

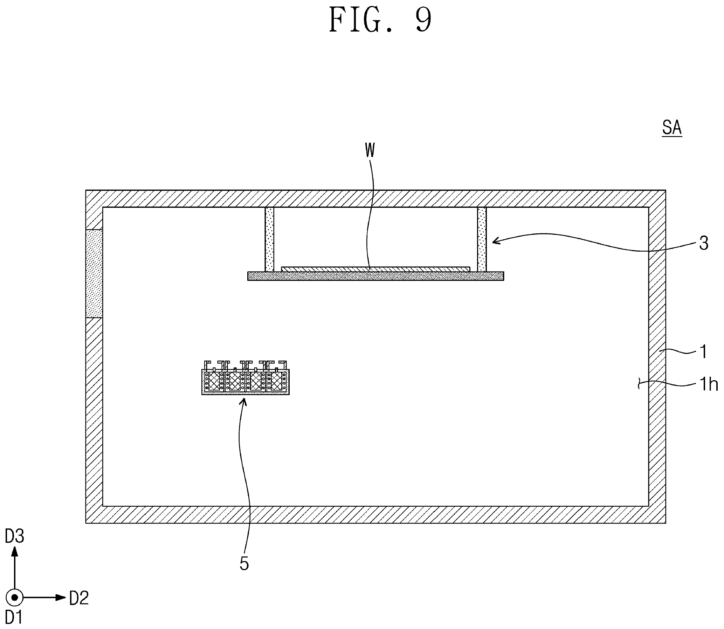

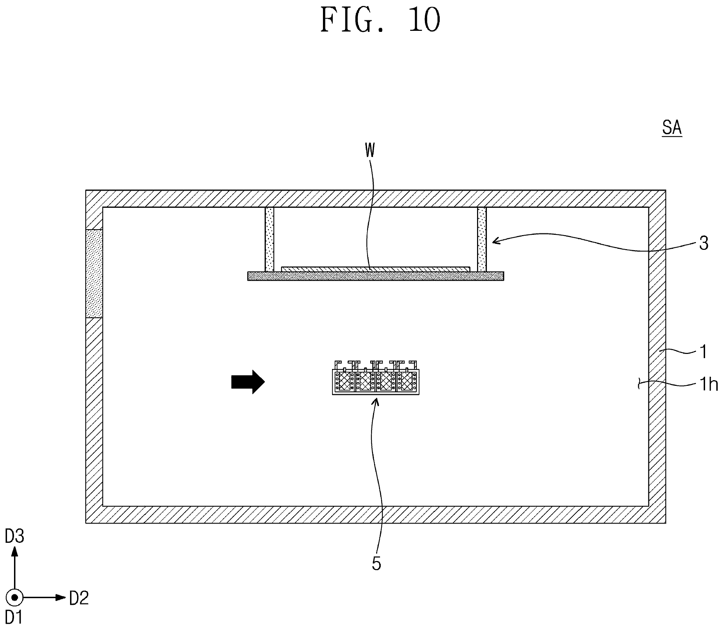

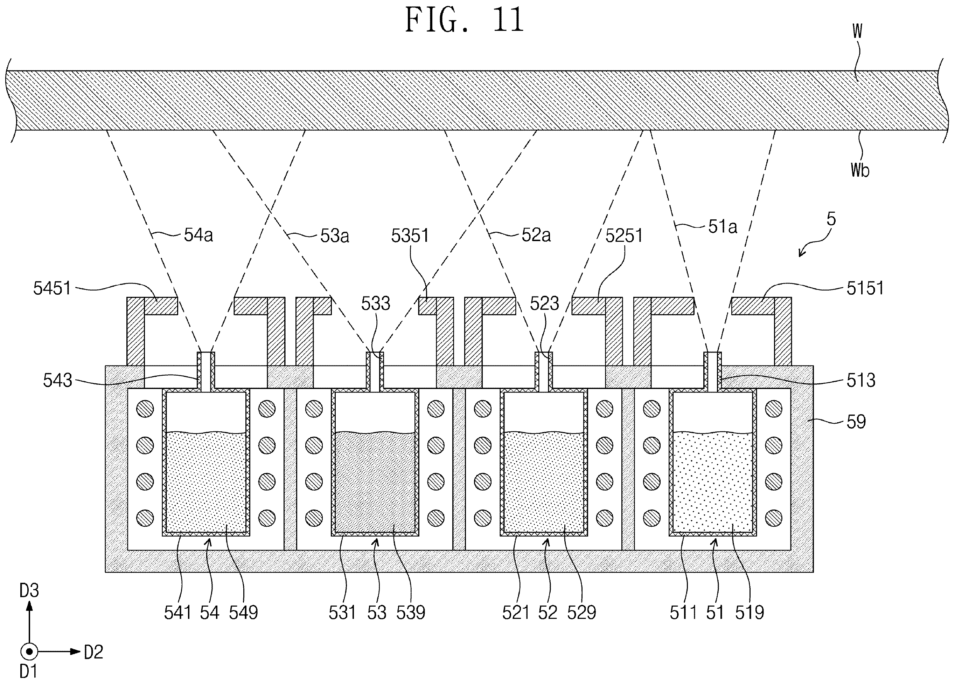

Hereinafter, the substrate deposition method S described with reference to FIG. 7 will be described in more detail with reference to FIGS. 8 to 11.

FIGS. 8 to 11 are views illustrating steps of the substrate deposition method according to the flowchart in FIG. 7.

Referring to FIGS. 7, 8, and 9, the substrate W may be disposed on the stage 3 by placing the substrate in the substrate deposition apparatus (S1). FIG. 8 shows a structure (or configuration) in which the substrate W is disposed only on the first stage 31; however, the present invention should not be limited thereto or thereby. In another embodiment, the substrate may be disposed on each of the first stage 31 and the second stage 33. In such an embodiment, processes for the two substrates may be sequentially or concurrently (or simultaneously) performed. Hereinafter, for the convenience of explanation, an embodiment in which the substrate W is disposed only on the first stage 31 will be described as a representative example.

Referring to FIGS. 8, 10, and 11, the heating of the deposition source module (S21) may include increasing a temperature of the first deposition material 519, the second deposition material 529, the third deposition material 539, and/or the fourth deposition material 549 by using the first heater 517 (see, e.g., FIG. 3), the second heater 527 (see, e.g., FIG. 3), the third heater 537 (see, e.g., FIG. 3), and/or the fourth heater 547 (see, e.g., FIG. 3). The first deposition source 51 and the second deposition source 52 may be heated at different temperatures from each other. In one embodiment, the first deposition source 51 may be heated at a first temperature, and the second deposition source 52 may be heated at a second temperature. The first temperature may be different from the second temperature. As an example, the first temperature may be within a range of about 200°C to about 400°C; however, the present invention should not be limited thereto or thereby. In the above descriptions, an embodiment in which the temperatures of the first deposition material 519, the second deposition material 529, the third deposition material 539, and/or the fourth deposition material 549 increase differently is described, but the present invention should not be limited thereto or thereby.

During the heating of the deposition source module (S21), the first deposition material 519 stored in the first deposition source 51 may be vaporized and may be discharged to the outside through the first nozzle 513. The first deposition material 51a discharged through the first nozzle 513 may reach a lower surface Wb of the substrate W after passing through the first blocking plate 5151. That is, the vaporized first deposition material 51a may be deposited on the substrate W.

During the heating of the deposition source module (S21), the second deposition material 529 stored in the second deposition source 52 may be vaporized and may be discharged to the outside through the second nozzle 523. The second deposition material 52a discharged through the second nozzle 523 may reach the lower surface Wb of the substrate W after passing through the second blocking plate 5251. That is, the vaporized second deposition material 52a may be deposited on the substrate W.

During the heating of the deposition source module (S21), the third deposition material 539 stored in the third deposition source 53 may be vaporized and may be discharged to the outside through the third nozzle 533. The third deposition material 53a discharged through the third nozzle 533 may reach the lower surface Wb of the substrate W through the third blocking plate 5351. That is, the vaporized third deposition material 53a may be deposited on the substrate W.

During the heating of the deposition source module (S21), the fourth deposition material 549 stored in the fourth deposition source 54 may be vaporized and may be discharged to the outside through the fourth nozzle 543. The fourth deposition material 54a discharged through the fourth nozzle 543 may reach the lower surface Wb of the substrate W after passing through the fourth blocking plate 5451. That is, the vaporized fourth deposition material 54a may be deposited on the substrate W.

A first area of the substrate W where the vaporized second deposition material 52a reaches the substrate W may not overlap a second area of the substrate W where the vaporized fourth deposition material 54a reaches the substrate W. The first area may have the same size as that of the second area; however, the present invention should not be limited thereto or thereby. According to an embodiment, the first area may partially overlap the second area. According to an embodiment, the first area may completely overlap the second area, and the first area may be the same as the second area. A third area of the substrate W where the vaporized first deposition material 51a reaches the substrate W may be narrower than the first area.

Through the moving of the deposition source module (S22), the heated deposition source module 5 may move in the direction parallel to the second direction D2. Accordingly, the deposition layer may be entirely formed on the lower surface Wb of the substrate W.

According to the substrate deposition apparatus and the substrate deposition method using the substrate deposition apparatus, four deposition sources may be used for the deposition on the substrate W, and thus, various deposition structures may be implemented. In such an embodiment, when the second deposition material is the same as the fourth deposition material, a durability of the deposition layer may be improved, and a lifespan of the manufactured product may be lengthened.

According to the substrate deposition apparatus and the substrate deposition method using the substrate deposition apparatus, multiple deposition sources including the same deposition material may be provided. For example, the linear deposition method may be implemented. Therefore, the deposition layer may be deposited over the entire substrate at once, and thus, the process may be performed quickly.

According to the substrate deposition apparatus and the substrate deposition method using the substrate deposition apparatus, the deposition sources may be arranged more densely at the edge (or end) than at the center. Accordingly, a phenomenon in which a thickness of the deposition layer decreases at an edge of the substrate may be prevented, and thus, the deposition layer may be formed more uniformly.

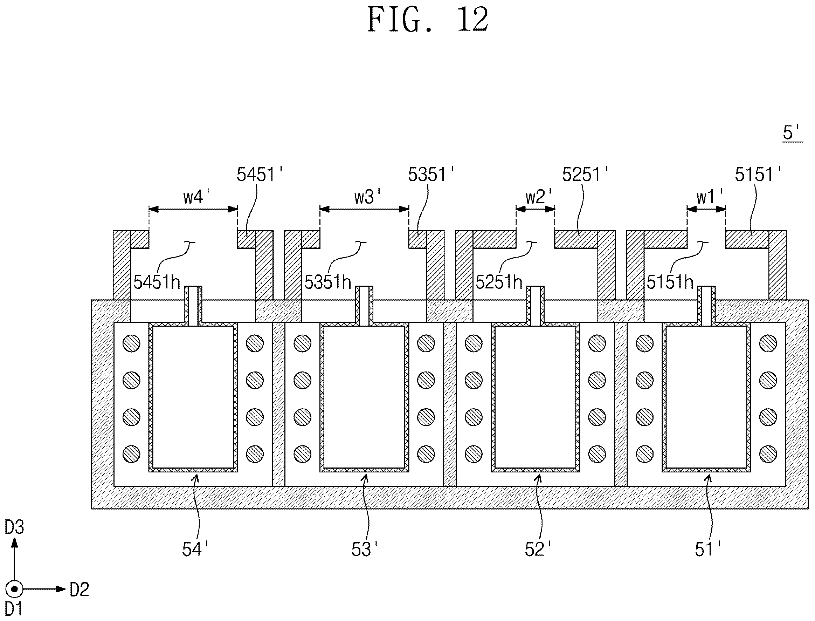

FIG. 12 is a cross-sectional view of a deposition source module 5' according to an embodiment of the present invention.

In FIG. 12, the same reference numerals denote the same elements in FIGS. 1 to 11, and thus, detailed descriptions of the same elements will be omitted or only briefly repeated.

Referring to FIG. 12, the deposition source module 5' may be provided. The deposition source module 5' may include a first deposition source 51', a second deposition source 52', a third deposition source 53', and a fourth deposition source 54'.

The first deposition source 51' may include a first blocking plate 5151'. A width of a first blocking hole (e.g., a first blocking opening) 5151h' in the first blocking plate 5151' may be referred to as a first width w1'.

The second deposition source 52' may include a second blocking plate 5251'. A width of a second blocking hole (e.g., a second blocking opening) 5251h' in the second blocking plate 5251' may be referred to as a second width w2'. Different from the descriptions with reference to FIG. 3, the second width w2' may be substantially the same as or similar to the first width w1'.

The third deposition source 53' may include a third blocking plate 5351'. A width of a third blocking hole (e.g., a third blocking opening) 5351h' in the third blocking plate 5351' may be referred to as a third width w3'. The third width w3' may be different from the first width w1'. As an example, the third width w3' may be greater than the first width w1'.

The fourth deposition source 54' may include a fourth blocking plate 5451'. A width of a fourth blocking hole (e.g., a fourth blocking opening) 5451h' in the fourth blocking plate 5451' may be referred to as a fourth width w4'. Different from the descriptions with reference to FIG. 4, the fourth width w4' may be substantially the same as or similar to the third width w3'.

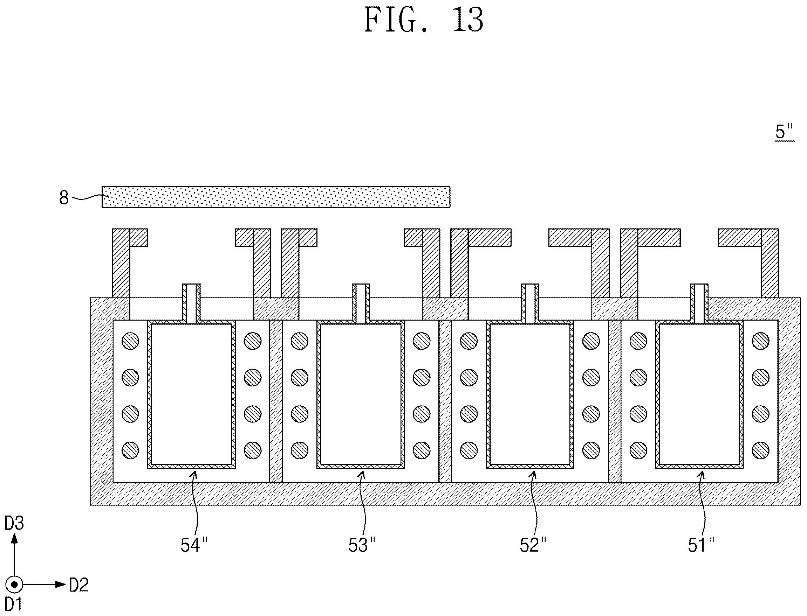

FIG. 13 is a cross-sectional view of a deposition source module 5" according to an embodiment of the present invention.

In FIG. 13, the same reference numerals denote the same elements in FIGS. 1 to 12, and thus, detailed descriptions of the same elements will be omitted or only briefly repeated.

Referring to FIG. 13, the deposition source module 5" may be provided. The deposition source module 5" may include a first deposition source 51", a second deposition source 52", a third deposition source 53", and a fourth deposition source 54". A shutter 8 may be further disposed above the deposition source module 5". The shutter 8 may be disposed above at least one of the first deposition source 51", the second deposition source 52", the third deposition source 53", and the fourth deposition source 54". According to an embodiment, the shutter 8 may move in the direction parallel to the second direction D2 to selectively cover at least one of the first deposition source 51", the second deposition source 52", the third deposition source 53", and the fourth deposition source 54".

According to the substrate deposition apparatus and the substrate deposition method using the substrate deposition apparatus, the shutter may be used to cover the deposition sources that are not in use. Accordingly, a variety of deposition layers may be implemented with a single deposition source module.

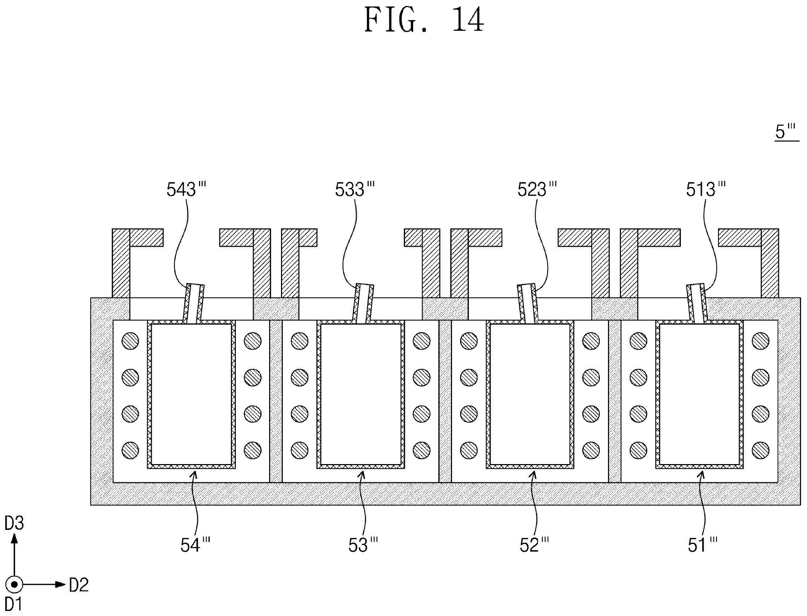

FIG. 14 is a cross-sectional view of a deposition source module 5‴ according to an embodiment of the present invention.

In FIG. 14, the same reference numerals denote the same elements in FIGS. 1 to 13, and thus, detailed descriptions of the same elements will be omitted or only briefly repeated.

Referring to FIG. 14, the deposition source module 5‴ may be provided. The deposition source module 5‴ may include a first deposition source 51‴, a second deposition source 52‴, a third deposition source 53"', and a fourth deposition source 54‴.

The first deposition source 51‴ may include a first nozzle 513‴. The second deposition source 52‴ may include a second nozzle 523‴. The third deposition source 53‴ may include a third nozzle 533‴. The fourth deposition source 54‴ may include a fourth nozzle 543‴. At least one of the first nozzle 513‴, the second nozzle 523‴, the third nozzle 533"', and the fourth nozzle 543‴ may form an acute angle with respect to the third direction D3. That is, different from the descriptions with reference to FIG. 4, the nozzle may not be oriented to the vertical direction.

According to the substrate deposition apparatus and the substrate deposition method using the substrate deposition apparatus, a width of a deposition area may be adjusted by controlling the direction of the nozzle. Accordingly, a variety of deposition layers may be implemented.

Although embodiments of the present invention have been described herein, it is understood that the present invention should not be limited to these embodiments but various changes and modifications can be made by one ordinary skilled in the art within the scope of the present invention as hereinafter claimed. Therefore, the disclosed subject matter should not be limited to any single embodiment described herein, and the scope of the present inventive concept shall be determined according to the attached claims.

## Claims

1. A substrate deposition method comprising:
placing a substrate (W) in a substrate deposition apparatus (SA); and
performing a deposition process on the substrate (W) in the substrate deposition apparatus (SA), the substrate deposition apparatus (SA) comprising:
a process chamber (1) having a process space (1h);
a stage (3) in the process chamber (1); and
a deposition source module (5), the deposition source module (5) comprising:
a plurality of first deposition sources (51) arranged in a first direction (D1) that is a horizontal direction;
a plurality of second deposition sources (52) arranged in the first direction (D1);
a plurality of third deposition sources (53) arranged in the first direction (D1); and
a plurality of fourth deposition sources (54) arranged in the first direction (D1),
wherein the performing of the deposition process on the substrate (W) comprises:
heating the deposition source module (5); and
moving the deposition source module (5) in a direction parallel to a second direction (D2) that is a horizontal direction intersecting the first direction (D1).

2. The substrate deposition method of claim 1, wherein the second deposition sources (52) are spaced apart from the first deposition sources (51) in a direction parallel to the second direction (D2).

3. The substrate deposition method of claim 1 or 2, wherein each of the first deposition sources (51) comprises a first deposition material (519), each of the second deposition sources (52) comprises a second deposition material (529), each of the third deposition sources (53) comprises a third deposition material (539), each of the fourth deposition sources (54) comprises a fourth deposition material (549), and
wherein the heating of the deposition source module (5) comprises:
vaporizing the first deposition material (519) in the first deposition sources (51) to be deposited on the substrate (W);
vaporizing the second deposition material (529) in the second deposition sources (52) to be deposited on the substrate (W);
vaporizing the third deposition material (539) in the third deposition sources (53) to be deposited on the substrate (W); and
vaporizing the fourth deposition material (549) in the fourth deposition sources (54) to be deposited on the substrate (W).

4. The substrate deposition method of claim 3, wherein the second deposition material (529) is the same as the fourth deposition material (549).

5. The substrate deposition method of claim 3 or 4, wherein an area where the second deposition material (529) is deposited on the substrate (W) in the vaporizing of the second deposition material (529) is the same as an area where the fourth deposition material (549) is deposited on the substrate (W) in the vaporizing of the fourth deposition material (549).

6. The substrate deposition method of claim 3 or 4, wherein a first area where the second deposition material (529) is deposited on the substrate (W) in the vaporizing of the second deposition material (529) does not overlap a second area where the fourth deposition material (549) is deposited on the substrate (W) in the vaporizing of the fourth deposition material (549), and
wherein the first area has a same size as the second area.

7. The substrate deposition method of at least one of claims 1 to 6, wherein, in the heating of the deposition source module (5), a temperature of the deposition source module (5) is within a range of about 200°C to about 400°C.

8. The substrate deposition method of at least one of claims 3 to 7, wherein an area where the first deposition material (519) is deposited on the substrate (W) in the vaporizing of the first deposition material (519) is narrower than an area where the second deposition material (529) is deposited on the substrate (W) in the vaporizing of the second deposition material (529).

9. A substrate deposition method comprising:
placing a substrate (W) in a substrate deposition apparatus (SA); and
performing a deposition process on the substrate (W) using the substrate deposition apparatus (SA), the substrate deposition apparatus (SA) comprising:
a process chamber (1) having a process space (1h);
a stage (3) in the process chamber (1); and
a deposition source module (5), the deposition source module (5) comprising a first deposition source (51), a second deposition source (52), a third deposition source (53), and a fourth deposition source (54), which are sequentially arranged in a horizontal direction,
wherein the performing of the deposition process on the substrate (W) comprises:
heating the deposition source module (5); and
moving the deposition source module (5) in the horizontal direction, and
wherein the first deposition source (51) comprises a first deposition material (519), the second deposition source (52) comprises a second deposition material (529) different from the first deposition material (519), the third deposition source (53) comprises a third deposition material (539) different from the second deposition material (529), the fourth deposition source (54) comprises a fourth deposition material (549) that is the same as the second deposition material (529).

10. The substrate deposition method of claim 9, wherein each of the first, second, third, and fourth deposition sources (51, 52, 53, 54) is provided in plural.

11. The substrate deposition method of claim 10, wherein the first deposition sources (51) are arranged in a first direction (D1), the second deposition sources (52) are arranged in the first direction (D1), and the second deposition sources (52) are spaced apart from the first deposition sources (51) in a direction parallel to a second direction (D2) intersecting the first direction (D1).

12. The substrate deposition method of claim 11, wherein a separation distance (DS1) in the first direction (D1) between two of the first deposition sources (51) at an edge from among the first deposition sources (51) is smaller than a separation distance (DS2) in the first direction (D1) between two of the first deposition sources (51) at a center from among the first deposition sources (51).

13. The substrate deposition method of at least one of claims 1 to 12, wherein, in the heating of the deposition source module (5), the first deposition source (51) is heated at a first temperature, the second deposition source (52) is heated at a second temperature that is different from the first temperature.

14. The substrate deposition method of at least one of claims 1 to 13, wherein the first deposition material (519) comprises Al(C₉H₆NO)₃.

15. The substrate deposition method of at least one of claims 1 to 14, wherein the performing of the deposition process on the substrate (W) comprises arranging a shutter (8) above at least one of the first, second, third, and fourth deposition sources (51, 52, 53, 54).

16. A substrate deposition apparatus (SA) comprising:
a process chamber (1) having a process space (1h);
a stage (3) in the process chamber (1); and
a deposition source module (5), the deposition source module (5) comprising:
a plurality of first deposition sources (51) arranged in a first direction (D1) that is a horizontal direction;
a plurality of second deposition sources (52) arranged in the first direction (D1);
a plurality of third deposition sources (53) arranged in the first direction (D1); and
a plurality of fourth deposition sources (54) arranged in the first direction (D1),
wherein the second deposition sources (52) are spaced apart from the first deposition sources (51) in a direction parallel to a second direction (D2) intersecting the first direction (D1).

17. The substrate deposition apparatus (SA) of claim 16, wherein each of the first deposition sources (51) comprises:
a first deposition housing (511); and
a first nozzle (513) on the first deposition housing (511).

18. The substrate deposition apparatus (SA) of claim 17, wherein each of the first deposition sources (51) further comprises a first blocking plate (5151) above the first nozzle (513) and having a first blocking hole (5151h).

19. The substrate deposition apparatus (SA) of claim 17 or 18, wherein each of the second deposition sources (52) comprises:
a second deposition housing (521);
a second nozzle (523) on the second deposition housing (521); and
a second blocking plate (5251) above the second nozzle (523) and having a second blocking hole (5251h),
wherein each of the third deposition sources (53) comprises:
a third deposition housing (531);
a third nozzle (533) on the third deposition housing (531); and
a third blocking plate (5351) above the third nozzle (533) and having a third blocking hole (5351h),
wherein each of the fourth deposition sources (54) comprises:
a fourth deposition housing (541);
a fourth nozzle (543) on the fourth deposition housing (541); and
a fourth blocking plate (5451) above the fourth nozzle (543) and having a fourth blocking hole (5451h), and
wherein the first blocking hole (5151h) has a width (w1) different from a width (w2) of the second blocking hole (5251h), and the fourth blocking hole (5451h) has a width (w4) that is the same as the width (w2) of the second blocking hole (5251h).

20. The substrate deposition apparatus (SA) of at least one of claims 16 to 19, wherein a separation distance (DS1) in the first direction (D1) between two of the first deposition sources (51) at an edge from among the first deposition sources (51) is smaller than a separation distance (DS2) in the first direction (D1) between two of the first deposition sources (51) at a center from among the first deposition sources (51).
